Europäisches Patentamt

(19) European Patent Office

Office européen des brevets

(11) Numéro de publication: **0 128 828**

**B1**

(12) # FASCICULE DE BREVET EUROPÉEN

(45) Date de publication du fascicule du brevet:
13.01.88

(51) Int. Cl.⁴: **H 01 L 27/14, H 04 N 3/15**

(21) Numéro de dépôt: **84401168.4**

(22) Date de dépôt: **06.06.84**

(54) **Dispositif photosensible à l'état solide.**

(30) Priorité: **14.06.83 FR 8309827**

(43) Date de publication de la demande:
**19.12.84 Bulletin 84/51**

(45) Mention de la délivrance du brevet:
**13.01.88 Bulletin 88/2**

(84) Etats contractants désignés:
**DE GB**

(56) Documents cité:
**EP-A-0 028 960**
**EP-A-0 038 725**
**US-A-4 087 833**

**IEEE TRANSACTIONS ON ELECTRON DEVICES,
vol. ED-27, no. 1, janvier 1980, pages 175-188, IEEE,
New York, US; P. FELIX et al.: "CCD readout of
infrared hybrid focal-plane arrays"**

(73) Titulaire: **THOMSON- CSF, 173, Boulevard
Haussmann, F-75379 Paris Cédex 08 (FR)**

(72) Inventeur: **Arques, Marc, THOMSON- CSF SCPI
173, bld Haussmann, F-75379 Paris Cedex 08 (FR)**

(74) Mandataire: **Ruellan- Lemonnier, Brigitte,
THOMSON- CSF SCPI 19, avenue de Messine,
F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne les dispositifs photosensibles à l'état solide conformés au préambule de la revendication 1. Elle concerne plus particulièrement l'étage de lecture de ces dispositifs.

Les dispositifs photosensibles à l'état solide actuellement utilisés aussi bien dans le domaine du visible que de l'infrarouge sont constitués principalement par des cellules de détection photonique et d'intégration des charges et par un dispositif de lecture constitué d'au moins un registre à décalage à transfert de charge recevant en parallèle par l'intermédiaire d'une grille de transfert les charges intégrées dans la zone d'intégration des cellules et les délivrant en série vers un étage de lecture donnant en sortie un signal électrique d'analyse d'images.

L'utilisation d'un dispositif à transfert de charge ou CCD en langue anglaise dans le dispositif de lecture présente un certain nombre d'inconvénients. En effet pour obtenir un écoulement correct des charges d'un étage à l'autre du dispositif à transfert de charge, il est nécessaire que les potentiels électriques aillent en croissant de l'entrée du CCD vers la sortie. Or la tension de sortie du CCD étant bien souvent limitée par la tension maximale que peut supporter l'étage de sortie, il en résulte que la tension en entrée du CCD est faible, ce qui limite la quantité de charges pouvant être injectée dans l'étage d'entrée. Cette croissance progressive des potentiels peut être évitée en pulsant certaines tensions, mais cela se traduit alors par une plus grande complexité de l'électronique de commande.

D'autre part, lorsque le nombre de cellules de détection photonique est important, on est limité par l'inefficacité du transfert et le bruit de transfert du dispositif à transfert de charge, en particulier lorsque l'on travaille avec des quantités de charges importantes et a des fréquences de fonctionnement élevées.

On a déjà proposé dans la demande européenne EP-A-0 028 960 une matrice photosensible utilisant un dispositif de lecture qui n'est pas un dispositif à transfert de charge. Dans cette demande, chaque photodiode de la matrice est reliée à la grille d'un transistor d'amplification qui permet de lire le potentiel correspondant à la quantité de charges créées dans la photodiode. D'autre part, la photodiode est connectée à une ligne qui reçoit une impulsion de commande réalisant la remise à zéro de la photodiode.

La présente invention concerne une autre réalisation d'un dispositif photosensible muni d'un dispositif de lecture autre qu'un dispositif à transfert de charge.

La présente invention a donc pour objet un dispositif photosensible à l'état solide du type comportant au moins une cellule de détection photonique et d'intégration des charges reliée à un moyen de lecture en tension donnant en sortie un signal électrique d'analyse d'images, ce moyen de lecture étant associé à au moins un moyen d'adressage séquentiel et à des moyens de remise à zéro, caractérisé en ce que chaque moyen de lecture en tension est constitué par un transistor MOS-suiveur dont la source est connectée à une charge, le drain à une tension de polarisation et la grille à une diode permettant de lire le potentiel correspondant à la quantité de charges dans la zone d'intégration, les moyens de remise à zéro remettant à zéro la cellule de détection et d'intégration précédemment lue.

Ainsi, l'étage de lecture ne comportant plus de dispositif à transfert de charge, les inconvénients liés à ce type de dispositif sont donc supprimés.

D'autre part, le dispositif à transfert de charge est remplacé par un nombre limité de transistors MOS nécessitant moins de surface, ce qui permet une diminution importante des dimensions du dispositif photosensible ou l'intégration d'un plus grand nombre de cellules.

D'autres caractéristiques et avantages de la présente invention apparaîtront à la lecture de la description de divers modes de réalisation faite ci-après avec référence aux dessins ci-annexés dans lesquels:

- la figure 1 est une vue de dessus d'un dispositif photosensible du type barrette utilisé pour l'infrarouge, selon un mode de réalisation de la présente invention;

- la figure 2 est une représentation schématique d'un étage du dispositif de figure 1, et des potentiels de surface correspondants dans le substrat sur lequel est intégré le dispositif multiplexeur.

- la figure 3 est une vue de dessus d'un dispositif photosensible matriciel comportant un étage de lecture conforme à la présente invention;

- la figure 4 est une vue semblable à celle de la figure 2 dans le cas d'un dispositif photosensible utilisé dans le domaine du visible.

- la figure 5 est une vue de dessus d'encore un autre mode de réalisation d'un étage de lecture conforme à la présente invention.

Sur les différentes figures, les mêmes références désignent les mêmes éléments mais pour des raisons de clarté, les cotes et proportions des divers éléments ne sont pas respectées.

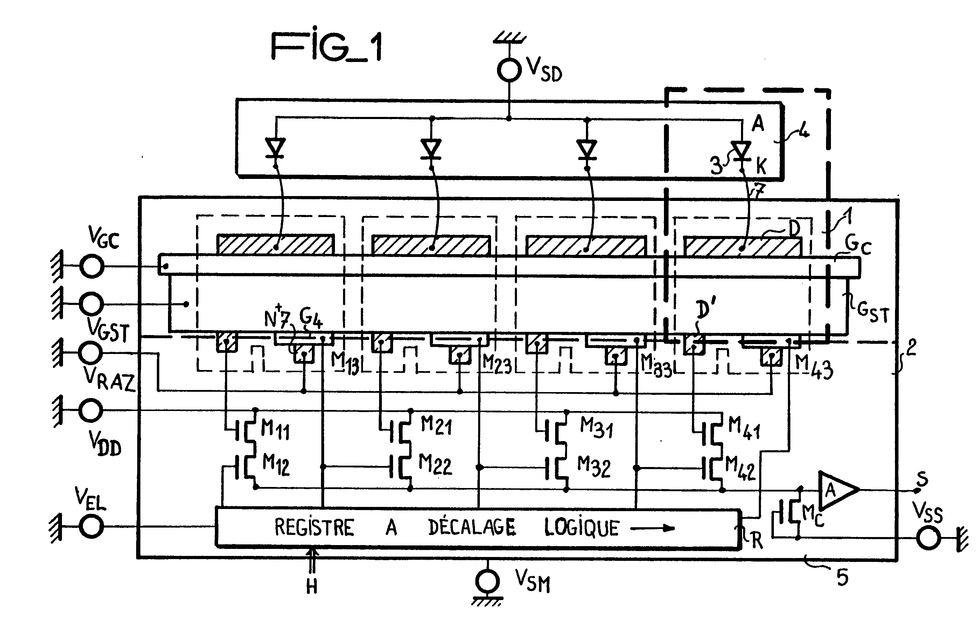

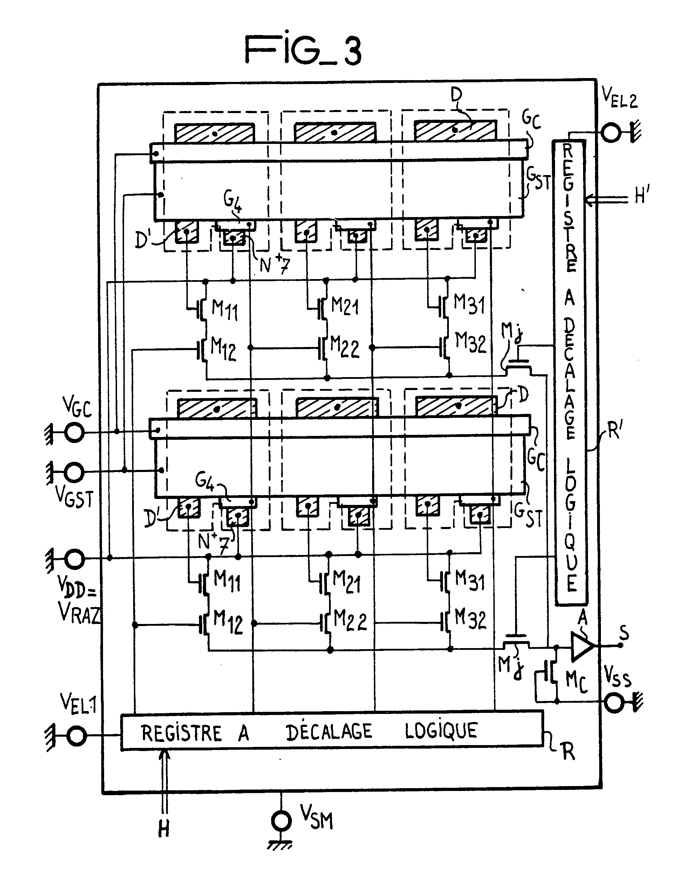

La figure 1 représente un dispositif photosensible utilisé dans le domaine de l'infrarouge. De manière connue, ce dispositif photosensible est constitué de cellules 1 de détection photonique et d'intégation des charges et d'un étage de lecture 2 donnant en sortie un signal électrique d'analyse d'images. A titre d'exemple, on a représenté sur la figure 1 un dispositif photosensible comportant quatre cellules. Il est bien entendu que le dispositif selon l'invention peut comporter un nombre plus élevé de cellules, lesdites cellules pouvant être alignées comme sur la figure 1 ou par exemple disposées en matrice comme expliqué ci-après avec référence à la figure 3.

Dans le domaine de l'infrarouge et comme représenté sur la figure 1, chaque cellule 1 comporte un détecteur photosensible 3 intégré sur un substrat semiconducteur 4 différent du substrat 5 sur lequel sont intégrés les autres éléments du dispositif photosensible et une zone d'intégration réalisée sur le substrat 5. Le substrat 4 est de préférence réalisé en tellurure de cadmium et de mercure, en tellurure d'étain et de plomb, ou en antimoniure d'indium. De même le substrat 5 est de préférence réalisé en silicium de type P, mais il pourrait être réalisé en silicium de type N dans le cas de diodes de détection a cathode commune, en arséniure de gallium ou en tout autre matérau semiconducteur équivalent.

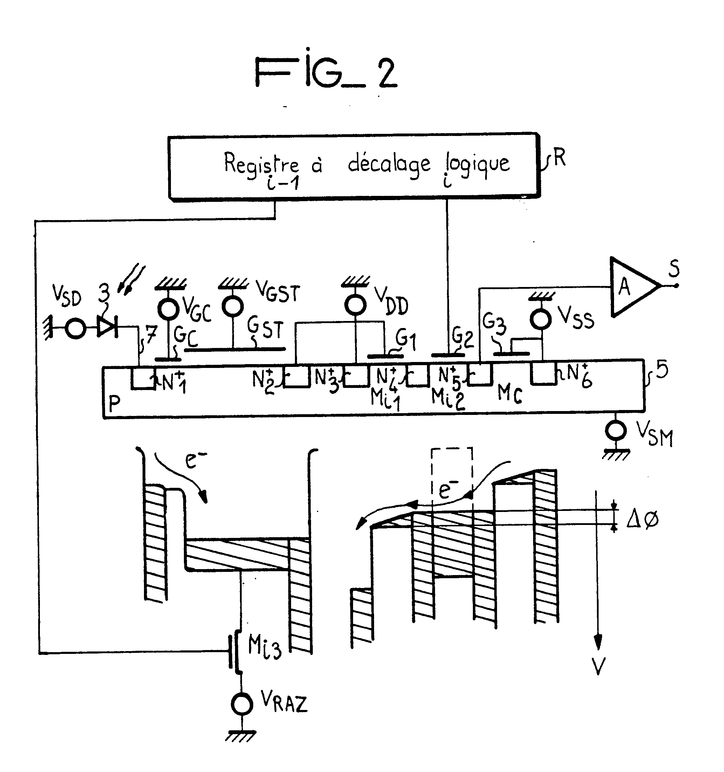

A titre d'exemple et comme représenté sur les figures 1 et 2, le détecteur photosensible 3 utilisé dans la présente invention est une photodiode. Toutefois, il est évident pour l'homme de l'art que l'invention s'applique quel que soit le détecteur utilisé.

Ainsi comme représenté sur les figures 1 et 2, l'anode A de la photodiode 3 reçoit une tension de polarisation $V_{SD}$. Sa cathode K est reliée par une connexion 7 à la zone d'intégration des charges qui permet d'intégrer dans le substrat 5 les charges créées dans la photodiode 3 par le rayonnement à détecter symbolisé par les flèches ondulées sur la figure 2.

D'autre part, chaque zone d'integration des charges réalisé sur le substrat semiconducteur 5 qui est polarisé à une tension $V_{SM}$ comporte une diode D constituée par une zone de type N réalisee dans le substrat semiconducteur 5 en silicium de type P. Cette zone est désignée par la reference $N_1^+$ sur la figure 2. Chaque diode est reliée par une des connexions 7 à la cathode K de la photodiode correspondante. D'autre part, une grille $G_C$ reliée à une tension de polarisation $V_{GC}$ sépare chaque diode D d'une capacité de stockage des charges constituée par une partie d'une grille $G_{ST}$, une couche d'isolant et le substrat. Sur la figure 2, par souci de clarté, on n'a pas représenté la couche d'isolant qui sépare les diverses grilles de la surface du substrat semiconducteur 5.

De même, comme représenté sur les figures 1 et 2, conformément à la prèsente invention, l'étage de lecture 2 comporte quatre moyens de lecture en tension constitués par des transistors MOS $M_{i1}$ montés en suiveur. La grille $G_1$ de chaque transistor MOS $M_{i1}$ est reliée à une diode D' adjacente à la capacité de stockage de chaque cellule 1 de détection et d'intégration des charges. Cette diode D' est réalisée par une diffusion de type N désignée par la référence $N_2^+$ sur la figure 2. Le role de cette diode D' sera expliqué ci-après de manière plus détaillée avec référence aux potentiels de surface représentés sur la figure 2. Le drain des transistors MOS $M_{i1}$ réalisé par la diffusion de type N référencée $N_3^+$ sur la figure 2 est relié à une tension de polarisation $V_{DD}$. D'autre part la source des transistors MOS $M_{i1}$ est connectée par l'intermédiaire de transistors MOS $M_{i2}$ jouant le rôle d'interrupteur à une charge $M_C$. On utilise, dans le mode de réalisation représenté, une charge unique pour tous les étages suiveurs ce qui permet de limiter la puissance. Toutefois, on pourrait aussi dans le cadre de l'invention, utiliser une charge par étage suiveur comme représenté par $M_{1C}$, $M_{2C}$ sur la figure 5. Dans ce cas, la source de chaque trasistor MOS $M_{i1}$ est connectée à la charge $M_{iC}$ et à un transistor MOS $M_{i2}$. Cette charge $M_C$ est constituée par un transistor MOS à déplétion dont la grille $G_3$ est connectée à la source réalisée par la diffusion de type N référencée $N_6^+$ sur la figure 2, cette source étant polarisée par une tension continue $V_{SS}$. Toutefois, la charge pourrait être réalisée par d'autres types de source de courant ou par une résistance.

D'autre part, chaque grille $G_2$ des transistors MOS interrupteurs $M_{i2}$ est reliée à une des sorties d'un registre à décalage logique R à entrée série et sorties parallèles. Comme expliqué de manière plus détaillée ci-après, le registre à décalage R permet d'adresser et de rendre passant un des transistors MOS $M_{i2}$, en conséquence d'effectuer le multiplexage des différents étages suiveurs.

L'étage de lecture 2 comporte de plus des moyens de remise à zéro. Ces moyens de remise à zéro sont réalisés par des transistors MOS $M_{i3}$ dont la porte $G_4$ est connectée à la sortie du registre à décalage logique R correspondant à l'étage suiveur précédent. La source induite des transistors MOS $M_{i3}$ est constituée par la capacité de stockage de la zone d'intégration correspondante et le drain réalisé par une diffusion de type N référencé $N_7^+$ est connecté à une tension continue $V_{RAZ}$. Dans le mode de réalisation représenté, on utilise le même registre à décalage logique R pour commander les trasistors MOS interrupteur $M_{i2}$ et les transistors MOS $M_{i3}$ de remise à zéro ce qui nécessite un étage de plus que le nombre de cellules ou l'utilisation d'un registre à décalage bouclé. Toutefois, on pourrait envisager d'utiliser deux registres a décalage indépendants.

On va expliquer maintenant le fonctionnement du dispositif décrit ci-dessus avec référence en particulier à la partie inférieure de la figure 2. Cette partie représente le potentiel de surface dans le substrat 5 lors de la lecture d'un étage.

La partie gauche représente le potentiel sous la zone d'intégration d'une cellule 1 qui est réalisée de manière connue par la diode D, la grille $G_C$ et la capacité de stockage $G_{ST}$ constituant un transistor MOS dont la diode D est la source et dont la capacité est le drain induit.

Ce transistor MOS est polarisé en régime de saturation car la tension $V_{GST}$ appliqué à la grille $G_{ST}$ est supérieure à la tension continue $V_{GC}$ appliquée à la grille $G_C$. Le niveau des charges sur la diode D s'aligne sur le potentiel proche du potentiel constant existant sous la grille $G_C$. La cathode K de la photodiode est polarisée par la tension continue $V_{SD}$ choisie pour être par exemple égale à 0 Volt.

Les charges créées dans le détecteur par le rayonnement sont stockées dans la capacité sous la grille de stockage polarisée par $V_{GST}$ comme cela est représenté symboliquement sur la figure 2, où les zones hachurées indiquent la présence de porteurs minoritaires par rapport au substrat 5.

La lecture des charges intégrées dans une des zones d'intégration est réalisée lorsque la sortie i correspondante du registre à décalage R est au niveau logique 1 de sorte que la grille du trasistor MOS $M_{i2}$ correspondant reçoive une tension élevée rendant passant ledit transistor, toutes les grilles des autres transistors MOS jouant le role d'interrupteur recevant un niveau logique 0 bloquant lesdits transistors. Dans ce cas, le transistor MOS $M_{i2}$ se comporte comme une résistance, le transistor MOS $M_C$, à savoir la charge, se trouve connecté au transistor suiveur $M_{i1}$ et on obtient donc un étage suiveur classique, la tension de polarisation $V_{DD}$ étant choisie très supérieure à la tension de polarisation $V_{SS}$ comme représenté sur la figure 2.

La diffusion $N_2^+$ realisée à droite de la grille de stockage $G_{ST}$ et connectée à la grille $G_1$ du transistor MOS $M_{i1}$ permet d'obtenir au niveau de cette grille un potentiel représentatif du potentiel sous la grille de stockage.

En effet comme représenté sur la figure 2 le potentiel au niveau de la diffusion $N_2^+$ est toujours égal au potentiel sous la grille $G_{ST}$ quel que soit ce potentiel. Comme la diffusion $N_2^+$ à savoir la diode D' est reliée à la grille $G_1$, le potentiel sous cette grille s'aligne, en prenant en compte la différence de potentiel due à l'isolant, sur le potentiel au niveau de la diffusion $N_2^+$.

De plus, comme dans le cas de la lecture le transistor $M_{i2}$ est équivalent à une résistance, le potentiel au niveau de la diffusion $N_5^+$ s'aligne sur le potentiel au niveau de la diffusion $N_4^+$. Or le potentiel au niveau de la diffusion $N_4^+$ est fonction du potentiel sous la grille $G_1$, car dans un étage suiveur la différence de potentiel $\Delta \emptyset$ est une constante. On obtient donc au niveau de la diffusion $N_5^+$ une tension représentative de la tension sous la grille de stockage. Cette tension est envoyée à travers un amplificateur A sur la borne de sortie S du dispositif photosensible.

On a représenté en pointillé sur la figure 2, le potentiel sous la grille $G_2$ lorsqu'un niveau logique 0 est appliqué sur cette grille. On voit que, dans ce cas, le courant ne peut pas s'écouler du transistor MOS de charge $M_C$ vers le transistor MOS suiveur $M_{i1}$. En conséquence, seule l'entrée sélectionnée contribue à la consommation du circuit.

En ce qui concerne les différentes tensions de polarisation, elles doivent être choisies de telles sorte que

$V_{SM} \leqslant V_{SD}$

$V_{GC} \cong V_{SD} + V_T$ où $V_T$ est la tension de seuil d'un transistor MOS

$V_{SM} \leqslant V_{SS} \leqslant V_{DD}$

A tire d'exemples, les valeurs ci-après peuvent être prises pour les différentes tensions, en supposant que $V_T = 2$ Volts sur tous les transistors MOS sauf sur les transistors $M_C$, $M_iC$ où la tension de seuil est négative.

**Exemple 1**

$V_{SM} = 3$ V, $V_{SD} = 0$, $V_{GC} \cong 2$ V, $V_{SS} = 3$ V
$V_{GST} = 15$ V, $V_{RAZ} = 12$ V, $V_{DD} = 14$ V

**Exemple 2**

$V_{SM} = 1$ V, $V_{SD} = V_{SS} = 0$ V, $V_{GC} \cong 2$ V
$V_{GST} = V_{DD} = V_{RAZ} = 15$ V.

De plus $V_{EL}$ représente les impulsions logiques envoyées en entrée du registre R et qui sont décalées sous l'action d'impulsions horloge H.

Après avoir lu l'information sur l'entrée i, on décale le niveau logique "1" du registre à décalage R d'un étage sous l'action de l'horloge H. On réalise donc, la lecture de l'entrée i+1.

Conformément à la présente invention, le niveau logique "1" est appliqué sur la grille $G_4$ du transistor MOS $M_{i3}$ de remise à niveau qui est rendu passant. Les charges qui se trouvent sous la grille de stockage $G_{ST}$ sont alors évacuées vers la source de tension $V_{RAZ}$ qui peut être choisie égale à la tension $V_{DD}$. On effectue ainsi la réinitialisation de la valeur de la capcité de stockage de l'entrée i pendant la lecture de l'entrée i+1. En fait, pendant cette remise à zéro de la capacité de stockage, les charges délivrées par la photodiode sont directement évacuées vers la source de tension $V_{RAZ}$ et donc inexploitées. Toutefois, ceci n'est pas gênant, car le nombre de cellules de détection et d'intégration est en pratique relativement élevé et la fraction des charges inexploitées reste donc en réalité négligeable.

D'autre part selon une caractéristique supplémentaire de l'invention, en réglant convenablement la valeur de la tension du niveau logique "0" du registre à décalage, on assure une fonction d'anti-éblouissement. En effet, les charges en excès peuvent déborder par dessus la barrière de potentiel créée sous la grille $G_4$ vers la source de tension $V_{RAZ}$ avant que le débordement ne soit possible vers les autres étages d'entrée.

Cette fonction d'anti-éblouissement peut être réalisée de deux façons.

En utilisant, l'enseignement du brevet EP-A-0 098 191 au nom de THOMSON-CSF, on obtient un effet d'anti-éblouissement lorsque:

1. les substrats sont polarisés à des tensions $V_{SM}$ et $V_{SD}$ répondant aux équations suivantes
$V_{SD} < V_{SM}$
$|V_{SM} - V_{SD}| \geqslant |V_{comax}|$ où $V_{comax}$ est un majorant de la tension de circuit ouvert des photodiodes (de l'ordre de 20 à 50 mV) et,

2. l'une des grilles de l'étage d'entrée est commandée par une tension pulsée.

Dans le cas de la présente invention, seule la première condition doit être réalisée.

On peut alors créer entre les différents étages d'entrée, des barrières d'isolement suffisamment hautes pourqu'en cas de suréclairement, le point de polarisation de la photodiode puisse se déplacer de sa position nominale jusqu'au point de circuit ouvert où le courant de la photodiode s'annule avant qu'il y ait débordement vers les autres entrées. Ceci se produit si le niveau logique "0" est suffisamment bas. Si le niveau logique "0" n'est pas suffisamment bas, il y a débordement par dessus la barrière de potentiel créée sous la grille $G_4$ avant qu'on ait atteint le point de circuit ouvert. Toutefois, ce débordement se fait vers la tension de polarisation $V_{RAZ}$ ce qui n'est pas gênant. Dans les deux cas, il y a protection contre l'éblouissement.

D'autre part, si l'on n'utilise pas l'enseignement du brevet EP-A-0 098 191 la condition pour réaliser l'anti-éblouissement est que

le niveau logique "0" > $V_T$

En effet, en supposant $V_{SM} = V_{SD} = 0$, les barrières d'isolement entre étages d'entrée ne peuvent pas être inférieures à $V_{SM} = 0$. En particulier, on ne peut pas avoir des barrières d'isolement a - $|V_{comax}|$. Il en résulte que le courant de la photodiode ne peut jamais s'annuler. Il y aura donc débordement. Toutefois, on cherche à réaliser ce débordement sous la grille $G_4$ vers la tension $V_{RAZ}$ our qu'il ne soit pas gênant. Si les autres isolements entre étages d'entrée sont à $V_{SM} = 0$, il faut que le potentiel de surface sous la grille $G_4$ soit toujours supérieur à 0. Il faut donc que la tension appliquée sur la grille $G_4$ soit toujours supérieure à $V_T$, d'où la condition rappelée ci-dessus.

On décrira maintenant avec référence à la figure 3, l'application de la présente invention à un dispositif photosensible à l'état solide du type matriciel. Le dispositif matriciel représenté est constitué de deux lignes à trois cellules de détection et d'intégration. Pour simplifier le dessin, les photodiodes prévues sur un substrat indépendant n'ont pas été représentées. Chaque ligne présente la même structure que le dispositif photosensible décrit avec référence à la figure 1.

A chaque photodiode sont donc associés une diode D, une partie de la grille de controle $G_C$, une partie de la grille de stockage $G_{ST}$, un transistor MOS suiveur $M_{i1}$, un transistor MOS $M_{i2}$ jouant le rôle d'interrupteur et un transistor MOS $M_{i3}$ de remise à zéro. Toutefois le registre à décalage logique R commandant les transistors MOS $M_{i2}$ est commun à l'ensemble des lignes.

D'autre part dans le mode de réalisation représenté, le dispositif photosensible comporte une seule sortie S, le multiplexage des différentes lignes étant réalisé de manière semblable au multiplexage des différentes cellules dans le cas de la figure 1. A savoir, un transistor MOS $M_J$ jouant le rôle d'interrupteur est monté entre la source des transistors $M_{i2}$ et la charge unique $M_C$, ces transistors MOS $M_J$ étant commandés par un registre à décalage R' à entrée série/sorties parallèles dans lequel on fait avancer sous l'action d'une horloge H' un niveau logique 1.

L'horloge H' est choisie de manière que, pendant une impulsion, on fasse dèfiler tout le registre R.

D'autres modes de réalisation pourraient être envisagés.

Ainsi, on peut envisager de connecter en bout de chaque ligne une charge $M_C$ et un amplificateur A, les sorties de chacun des amplificateurs étant connectées à une entrée d'un multiplexeur qui peut être réalisé, par exemple, par un dispositif à transfert de charge ou par un réseau de transistors MOS.

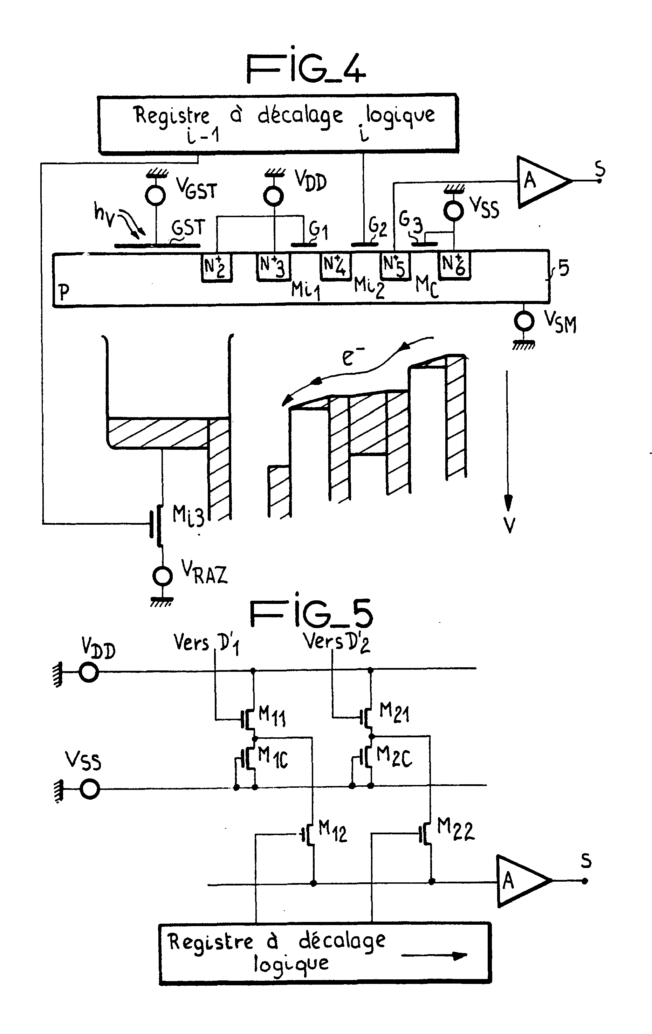

La figure 4 est une vue semblable à celle de la figure 2, la seule différence réside dans le fait que le dispositif photosensible à l'état solide étant destiné à détecter un rayonnement visible, les détecteurs sont intégrés sur le substrat 5. Dans le présent cas, la cellule de détection photonique et d'intégration est réalisée à l'aide d'un seul élément à savoir un photo MOS. Il ne reste plus au niveau de l'entrée des charges, qu'une seule grille de stockage $G_{ST}$ reliée à une tension de polarisation $V_{GST}$.

En ce qui concerne le fonctionnement des dispositifs des figures 3 et 4, il est identique à celui décrit avec référence a la figure 2 et il ne sera pas décrit à nouveau.

**Revendications**

1. Un dispositif photosensible à l'état solide du type comportant au moins une cellule (1) de détection photonique et d'intégration des charges reliée à un moyen de lecture en tension (2) donnant en sortie un signal électrique d'analyse d'images, ce moyen de lecture étant associé à au moins un moyen d'adressage séquentiel (R, $M_{i2}$) et à des moyens de remise à zéro ($M_{i3}$), caractérisé en ce que

- chaque moyen de lecture en tension est constitué par un transistor MOS-suiveur ($M_{i1}$) dont la source est connectée à une charge ($M_C$), le drain à une tension de polarisation ($V_{DD}$) et la grille à une diode (D') permettant de lire le potentiel correspondant à la quantité de charges dans la zone d'intégration; les moyens de remise à zéro ($M_{i3}$) remettant à zéro la cellule de détection et d'intégration précédemment lue.

2. Un dispositif photosensible selon la revendication 1, caractérisé en ce que la charge ($M_C$) est commune à l'ensemble des MOS-suiveurs ($M_{i1}$).

3. Un dispositif photosensible selon la revendication 2, caractérisé en ce que la charge ($M_C$) est connectée aux transistors MOS-suiveurs ($M_{i1}$) par l'intermédiaire du moyen d'adressage (R, $M_{i2}$).

4. Un dispositif photosensible selon l'une quelconque des revendications 1 à 3, caractérisé en ce que la charge ($M_C$) est constituée par une résistance de charge ou par un transistor MOS monté en source de courant.

5. Un dispositif photosensible selon l'une quelconque des revendications 1 à 4, caractérisé en ce que la diode (D') est réalisée par une diffusion ($N_2^+$) d'un type de dopage opposé à celui du substrat.

6. Un dispositif photosensible selon l'une quelconque des revendications 1 à 5, caractérisé en ce que le moyen d'adressage séquentiel est constitué par un registre à décalage logique (R) à entrée série et sorties parallèles dont chaque sortie est reliée par l'intermédiaire d'un interrupteur ($M_{i2}$) à un des moyens de lecture.

7. Un dispositif photosensible selon la revendication 6, caractérisé en ce que l'interrupteur est constitué par un transistor MOS ($M_{i2}$) monté entre chaque sortie des transistors MOS ($M_{i1}$)-suiveurs et la charge ($M_C$), la grille dudit transitor MOS ($M_{i2}$) étant commandée par une des sorties (i) du registre à décalage (R).

8. Un dispositif photosensible selon l'une quelconque des revendications 1 à 7, caractérisé en ce que chaque moyen de remise à zéro est constitué par un transistor MOS ($M_{i3}$) monté entre la zone d'intégration ($G_{ST}$) d'une cellule (1) et une tension de polarisation ($V_{RAZ}$), la grille dudit transitor MOS ($M_{i3}$) étant commandée par la sortie (i-1) du registre à décalage (R) correspondant au moyen de lecture précédent.

9. Un dispositif photosensible selon la revendication 8, caractérisé en ce que les transistors MOS ($M_{i3}$) des moyens de remise à zéro sont utilisés comme dispositif anti-éblouissement.

10. Un dispositif photosensible selon l'une quelconque des revendications 1 à 9, caractérisé en ce que, dans le cas d'un dispositif photosensible de type matriciel, il comporte de plus un moyen pour réaliser le multiplexage des différentes lignes de la matrice.

11. Un dispositif photosensible selon la revendication 10, caractérisé en ce que le moyen pour réaliser le multiplexage des différentes lignes de la matrice est constitué par un registre à décalage à transfert de charges à entrées parallèlles et sortie série, dont chaque entrée est connectée à la sortie de l'étage de lecture de chaque ligne.

12. Un dispositif photosensible selon la revendication 10, caractérisé en ce que le moyen pour réaliser le multiplexage des différentes lignes de la matrice est constitué par des interrupteurs ($M_J$) montés sur chaque ligne entre la sortie des interrupteurs ($M_{i2}$) de colonne et une charge unique ($M_C$), lesdits interrupteurs ($M_J$) étant commandés par un registre à décalage logique (R') à entrée série et sorties parallèles.

13. Un dispositif photosensible selon la revendication 12, caractérisé en ce que les interrupteurs sont constitués par des transistors MOS ($M_J$).

**Patentansprüche**

1. Lichtempfindliche Festkörperanordnung mit mindestens einer Zelle (1) zur Photonendetektion und zur Integration der Ladungen, die an ein Mittel (2) zum Ablesen der Spannungen angeschlossen ist, welches ausgangsseitig ein elektrisches Bildanalysesignal liefert und mindestens einem sequentiellen Adressiermittel (R, $M_{i2}$) und Nullsetzungsmitteln ($M_{i3}$) zugeordnet ist, dadurch gekennzeichnet, daß
- jedes Mittel zum Ablesen der Spannungen von einem MOS-Transistor ($M_{i1}$) in Folgeschaltung gebildet wird, dessen Source an eine Last ($M_C$), dessen Drain an eine Vorspannung ($V_{DD}$) und dessen Gate an eine Diode (D') angeschlossen ist, sodaß es möglich ist, das der Ladungsmenge in der Integrationszone entsprechende Potential abzulesen, wobei die Nullsetzungsmittel ($M_{i3}$) die vorher abgefragte Detektions- und Integrationszelle auf Null zurücksetzen.

2. Lichtempfindliche Anordnung nach Anspruch 1, dadurch gekennzeichnet, daß die Last ($M_C$) allen MOS-Folgeschaltungen ($M_{i1}$) gemeinsam ist.

3. Lichtempfindliche Anordnung nach Anspruch 2, dadurch gekennzeichnet, daß die Last ($M_C$) mit den Folgeschaltungs-MOS-Transistoren ($M_{i1}$) über das Adressiermittel (R, $M_{i2}$) verbunden ist.

4. Lichtempfindliche Anordnung nach einem beliebigen der Ansprüche 1 bis 3, dadurch gekennzeichnet, daß die Last ($M_C$) von einem Lastwiderstand oder einem MOS-Transistor gebildet wird, der als Stromquelle geschaltet ist.

5. Lichtempfindliche Anordnung nach einem beliebigen der Ansprüche 1 bis 4, dadurch gekennzeichnet, daß die Diode (D') durch eine Diffusion ($N_2^+$) eines Dotierungstyps entgegengesetzt dem des Substrats gebildet wird.

6. Lichtempfindliche Anordnung nach einem beliebigen der Ansprüche 1 bis 5, dadurch gekennzeichnet, daß das sequentielle Adressiermittel von einem logischen Schieberegister (R) mit Serieneingang und parallelen Ausgängen gebildet wird, wobei jeder Ausgang über einen Schalter ($M_{i2}$) an eines der Ablesemittel angeschlossen ist.

7. Lichtempfindliche Anordnung nach Anspruch 6, dadurch gekennzeichnet, daß jeder Schalter von einem MOS-Transistor ($M_{i2}$) gebildet wird, der zwischen jedem Ausgang der Folgeschaltungs-MOS-Transistoren ($M_{i1}$) und der Last ($M_C$) eingefügt ist, wobei das Gate dieses MOS-Transistors ($M_{i2}$) von einem der Ausgänge (i) ds Schieberegisters (R) gesteuert wird.

8. Lichtempfindliche Anordnung nach einem beliebigen der Ansprüche 1 bis 7, dadurch gekennzeichnet, daß jedes Nullsetzungsmittel von einem MOS-Transistor ($M_{i3}$) gebildet wird, der zwischen die Integrationszone ($G_{ST}$) einer Zelle (1) und eine Vorspannung ($V_{RAZ}$) eingeschaltet ist, wobei das Gate dieses MOS-Transistors ($M_{i3}$) von dem dem vorhergehenden Ablesemittel entsprechenden Ausgang (i-1) des Schieberegisters (R) gesteuert wird.

9. Lichtempfindliche Anordnung nach Anspruch 8, dadurch gekennzeichnet, daß die MOS-Transistoren ($M_{i3}$) der Nullsetzungsmittel als Flunkerschutzvorrichtung verwendet werden.

10. Lichtempfindliche Anordnung nach einem beliebigen der Ansprüche 1 bis 9, dadurch gekennzeichnet, daß sie im Fall einer lichtempfindlichen Anordnung vom Matrixtyp außerdem ein Mittel aufweist, mit dem die verschiedenen Zeilen der Matrix multiplexiert werden.

11. Lichtempfindliche Anordnung nach Anspruch 10, dadurch gekennzeichnet, daß das Mittel, mit dem die verschiedenen Zeilen der Matrix multiplexiert werden, von einem Ladungstransfer-Schieberegister mit parallelen Eingängen und Serienausgang gebildet wird, wobei jeder Eingang an den Ausgang der Ablesestufe jeder Zeile angeschlossen ist.

12. Lichtempfindliche Anordnung nach Anspruch 10, dadurch gekennzeichnet, daß das Mittel, mit dem die verschiedenen Zeilen der Matrix multiplexiert werden, von Schaltern ($M_J$) gebildet werden, die auf jeder Zeile zwischen den Ausgang des Spaltenschalters ($M_{i2}$) und eine gemeinsame Last ($M_C$) eingefügt sind, wobei diese Schalter ($M_J$) von einem logischen Schieberegister (R') mit Serieneingang und parallelen Ausgängen gesteuert werden.

13. Lichtempfindliche Anordnung nach Anspruch 12, dadurch gekennzeichnet, daß die Schalter von MOS-Transistoren ($M_J$) gebildet werden.

**Claims**

1. A photosensitive solid-state device of the type comprising at least one photon detection and charge integration cell (1) connected to a voltage read-out means (2) which delivers at its output an electric picture analyzing signal, this read-out means being associated to at least one sequential addressing means (R, $M_{i2}$) and to zero-setting means ($M_{i3}$), characterized in that
- each voltage read-out means is constituted by a MOS transistor follower ($M_{i1}$) the source of which is connected to a load ($M_C$), the drain of which is connected to a bias voltage ($V_{DD}$) and the gate of which is connected to a diode (D') allowing to read the potential corresponding to the quantity of charges present in the integration zone, the zero-setting means ($M_{i3}$) setting the detection and integration cell to zero after having been read out.

2. A photosensitive device according to claim 1, characterized in that the load ($M_C$) is common to all the MOS followers ($M_{i1}$).

3. A photosensitive device according to claim 2, characterized in that the load ($M_C$) is connected to the MOS followers ($M_{i1}$) via the addressing means (R, $M_{i2}$).

4. A photosensitive device according to anyone of claims 1 to 3, characterized in that the load ($M_C$) is constituted by a load resistor or by a MOS-transistor acting as current source.

5. A photosensitive device according to anyone of claims 1 to 4. Characterized in that the diode (D') is obtained by a doping diffusion ($N_2+$) of a type contrary to that of the substrate.

6. A photosensitive device according to anyone of claims 1 to 5, characterized in that the sequential addressing means is constituted by a logic shift register (R) having a series input and parallel outputs, each register output being connected to one of the read-out means via a switch ($M_{i2}$).

7. A photosensitive device according to claim 6, characterized in that the switch is constituted by a MOS transistor ($M_{i2}$) inserted between each output of the MOS transistor followers ($M_{i1}$) and the load ($M_C$), the gate of that MOS transistor ($M_{i2}$) being controlled by one of the outputs (i) of the shift register (R).

8. A photosensitive device according to anyone of claims 1 to 7, characterized in that each zero-setting means is constituted by a MOS transistor ($M_{i3}$) inserted between the integration zone ($G_{ST}$) of a cell (1) and a bias voltage ($V_{RAZ}$), the gate of said transistor being controlled by the one output (i-1) of the shift register (R) which corresponds to the preceding read-out means.

9. A photosensitive device according to claim 8, characterized in that the MOS transistors ($M_{i3}$) of the zero-setting means are used as anti-dazzling device.

10. A photosensitive device according to anyone of claims 1 to 9, characterized in that in the case of a matrix type photosensitive device it further comprises a means allowing to multiplex the different matrix lines.

11. A photosensitive device according to claim 10, characterized in that the means allowing to multiplex the different matrix lines is constituted by a charge-transfer shift register having parallel inputs and a series output, each input of which is connected to the output of the read-out stage of each line.

12. A photosensitive device according to claim 10, characterized in that the means allowing to multiplex the different matrix lines is constituted by switches ($M_J$) inserted in each line between the output of the column switches ($M_{i2}$) and a common load ($M_C$), said switches ($M_J$) being controlled by a logic shift register (R') having a series input and parallel outputs.

13. A photosensitive device according to claim 12, characterized in that the switches are constituted by MOS transistors ($M_J$).

FIG_1

# FIG_ 2

Registre à décalage logique — R
i-1          i

$V_{SD}$  3  $V_{GC}$  $V_{GST}$  $V_{DD}$  $G_3$  $V_{SS}$  A  S

$G_C$  $G_{ST}$  $G_1$  $G_2$

$N_1^+$  $N_2^+$  $N_3^+$  $N_4^+$  $N_5^+$  $N_6^+$  5

P  $Mi_1$  $Mi_2$  $M_C$

$V_{SM}$

$e^-$

$e^-$

$\Delta \emptyset$

$Mi_3$

$V_{RAZ}$

V

# FÍG_3

# FIG_4

Registre à décalage logique
i-1          i

# FIG_5

Registre à décalage logique